# EUROPEAN PATENT APPLICATION

(11) **EP 4 582 762 A1**
(43) Date of publication of application: **09.07.2025**
(21) Application number: 23859877.5
(22) Date of filing: 19.07.2023
(51) Int. Cl.: F28F 13/02, H01L 23/427, B23K 26/354, F28D 15/02, F28D 15/04

(54) **BOILING COOLER AND METHOD FOR MANUFACTURING BOILING COOLER**

(30) Priority: 02.09.2022 JP 2022140345
(71) Applicant: Sumitomo Precision Products Co., Ltd., Hyogo 660-0891 (JP)
(72) Inventor: YAMANAKA, Kiyoaki, Amagasaki-shi, Hyogo 660-0891 (JP); ANDO, Kenji, Amagasaki-shi, Hyogo 660-0891 (JP); TANABE, Akihiro, Amagasaki-shi, Hyogo 660-0891 (JP)
(74) Representative: Viering, Jentschura & Partner mbB Patent- und Rechtsanwälte
(86) International application number: PCT/JP2023/026464
(87) International publication number: WO 2024/048107

(57) **Abstract**

A boiling cooler (100) according to this invention includes a boiler (10) boiling a refrigerant (5) by transferring heat from a heat source (HS), and a condenser (20) condensing the refrigerant vaporized in the boiler and returning the condensed refrigerant to the boiler. The boiler includes a mounting surface (11a) on which the heat source is mounted, and a boiling surface part (13) on a surface (11b) that is opposite to the mounting surface and is in contact with the refrigerant. The boiling surface part includes a groove(s) (14) that extends/extend in a line shape and has/have an irregularly protruding/recessed shape shaped by melting and solidification of a material by energy beam processing.

## Description

### Technical Field

This invention relates to a boiling cooler and a method for producing a boiling cooler, in particular to a boiling cooler and a method for producing a boiling cooler including a boiler boiling a refrigerant and a condenser condensing the refrigerant and returning the condensed refrigerant to the boiler.

### Background Art

Boiling coolers including a boiler boiling a refrigerant and a condenser condensing the refrigerant and returning the condensed refrigerant to the boiler are known in the art. Such a boiling cooling is disclosed in Japanese Patent Laid-Open Publication No. JP 2016-114304, for example.

The above Japanese Patent Laid-Open Publication No. JP 2016-114304 discloses a boiling cooling apparatus (boiling cooler) including a heat receiver (boiler) boiling a refrigerant and a heat dissipater (condenser) condensing the refrigerant and returning the condensed refrigerant to the heat receiver. The heat receiver includes a heat source mount to which a to-be-cooled object is attached and a boiling heat transfer surface arranged on a back side of the heat source mount. The boiling heat transfer surface has a plurality of holes having rough interior surfaces and annular ridges arranged around openings of the holes formed by irradiation with an aluminum plate material with laser beam. All of the plurality of holes have circular shapes opened in the boiling heat transfer surface, and having the interior surfaces and bottom surfaces. The annular ridges are formed of droplets of melting aluminum, which is generated by irradiating the aluminum plate material with a high-energy beam, is scattered and adhered around the holes, and is deposited when solidifying.

In the above Japanese Patent Laid-Open Publication No. JP 2016-114304, heat emitted from a heat source is transferred to a refrigerant through the boiling heat transfer surface so that the liquid-phase refrigerant is boiled and vaporized to a gaseous state in a part in contact with the boiling heat transfer surface, and the heat produces bubbles on the boiling heat transfer surface and is released into the liquid-phase refrigerant. The above Japanese Patent Laid-Open Publication No. JP 2016-114304 states that, since the surfaces are rough, it is possible to improve a generation rate of bubbles on the interior surfaces of the holes and on surfaces of the annular ridges, and to allow the annular ridges to prevent surfaces of the boiling heat transfer surface from being covered by vapor film whereby delaying occurrence of burnout.

### Prior Art

### Patent Document

Patent Document 1: Japanese Patent Laid-Open Publication No. JP 2016-114304

### Summary of the Invention

### Problems to be Solved by the Invention

However, in the above Japanese Patent Laid-Open Publication No. JP 2016-114304, while the generation rate of bubbles inside the holes is improved, the liquid-phase refrigerant can enter the holes only through the openings. Also, since the openings of the holes are surrounded by the annular ridges, the liquid-phase refrigerant cannot easily flow into the openings. For this reason, when bubbles are released from interiors of the holes, the liquid-phase refrigerant outside the holes cannot be easily smoothly supplied to the interiors of the holes, consequently the interiors of the holes are continuously filled with bubbles and are likely to be dry (dryout). It is considered that dryout is likely to occur in the interiors of the holes in particular under condition in which the input heat per unit time (heat flux) is large. If the interiors of the holes are brought in such a dryout state, the dryout state becomes a factor in reduction of heat transfer efficiency of the boiling heat transfer surface. From this viewpoint, it is desired to prevent occurrence of localized dryout while increasing the generation rate of bubbles by forming protrusions/recesses.

The present invention is intended to solve the above problem, and one object of the present invention is to provide a boiling cooler and a method for producing a boiling cooler capable of preventing occurrence of localized dryout while increasing a generation rate of bubbles by forming protrusions/recesses on a boiling surface part.

### Means for Solving the Problems

In order to attain the aforementioned object, a boiling cooler according to a first aspect of the present invention includes a boiler boiling a refrigerant by transferring heat from a heat source; and a condenser condensing the refrigerant vaporized in the boiler and returning the condensed refrigerant to the boiler, wherein the boiler includes a mounting surface on which the heat source is mounted, and a boiling surface part on a surface that is opposite to the mounting surface and is in contact with the refrigerant, and the boiling surface part includes a groove(s) that extends/extend in a line shape and has/have an irregularly protruding/recessed shape shaped by melting and solidification of a material by energy beam processing.

Here, the term "energy beam" refers to a broad sense that includes a converged beam of particles having energy, such as a laser beam, electron beam, and an ion beam. The "irregularly protruding/recessed shape shaped by melting and solidification of a material by energy beam processing" refers to an irregularly protruding/recessed shape peculiar to energy beam processing shaped on the boiling surface part, when conducting groove-formation processing by irradiating a surface of a material, which forms the boiling surface part, with an energy beam, resulting from rapid melting and/or evaporation of the material caused by a temperature rise produced on the surface of the material, scattering of the melting and/or evaporated material, deposition of the material after scattered, and the like.

In the boiling cooler according to a first aspect of the present invention, as discussed above, the boiling surface part includes a groove(s) that extends/extend in a line shape and has/have an irregularly protruding/recessed shape shaped by melting and solidification of a material by energy beam processing. Accordingly, the groove(s) having the irregularly protruding/recessed shape and formed on the boiling surface part serves/serve as a starting point of nucleate boiling, and improves/improve a generation rate of bubbles. Also, since the protruding/recessed shape is not a hole whose perimeter is closed but a groove extending in a line shape, no wall is formed at least an extension direction of the groove(s) so that the liquid-phase refrigerant can flow through the groove(s). In other words, since a pair of interior surfaces are formed in a width direction of the groove(s), the generation rate of bubbles can be increased by securing a large heat transfer area to the liquid-phase refrigerant; and since no interior surfaces are formed in the extension direction of the groove(s), the liquid-phase refrigerant can be smoothly supplied from the outside of the groove(s) into the groove(s) when the bubbles generated leave the groove(s). Consequently, it is possible to prevent occurrence of localized dryout while increasing the generation rate of bubbles on the boiling surface part by forming protrusions/recesses.

In the first aspect of the present invention, it is preferable that the groove(s) includes/include a space formed of at least one of a hole opened in the boiling surface part, a hollow with at least a part of an opened part of the hole being covered, a lateral hole extending laterally from the hole or the hollow, and a tunnel-shaped pathway with a part of an opening in the groove being covered. Here, the "hole opened in the boiling surface part" refers to a part of the interior surface of the groove that is a localized hole (recess) whose perimeter is closed and whose upper end is free (opened). The "hollow" refers to a part that is a hole which is formed by the energy beam resulting from deposition of the material scattered by irradiation with the energy beam and whose opening is partially or entirely covered. The "lateral hole" refers to a space that is recessed toward a lateral side, which is different from a depth direction of the groove(s) (i.e., an irradiation direction of the energy beam), resulting from rapid expansion or the like of the material caused by the irradiation with the energy beam. The tunnel-shaped pathway refers to a space that is formed in a tunnel shape having a roof shape covering a part of an opening of a groove (a longitudinal part of the groove) resulting from deposition of the material scattered by irradiation with the energy beam. The starting point of nucleate boiling can be be effectively formed on the boiling surface part by forming the groove(s) including the space having such a protruding/recessed shape. Consequently, it is possible to effectively improve the generation rate of bubbles on the boiling surface part.

In this configuration, it is preferable that the space has a structure partially formed in the groove. According to this configuration, a very small space suitable for generation of bubbles can be provided in the groove as a partial structure of the groove.

In the first aspect of the present invention, it is preferable that the groove(s) at least partially has/have a bottom wider than an opening width of the groove in a cross section perpendicular to an extension direction of the groove(s). According to this configuration, since a width of the interior space of the groove is larger than an opening width of the groove, and the interior space is formed to surround a bubble generated on a bottom of the groove from both sides to the opening, it is possible to increase an interior surface area (heat transfer area) of the groove. Consequently, it is possible to efficiently transfer heat the refrigerant in the groove.

In the first aspect of the present invention, it is preferable that the grooves are a plurality of grooves formed in the boiling surface part; and that the plurality of grooves include two or more first grooves extending in a first direction along the boiling surface part, and two or more second grooves extending in a second direction different from the first direction along the boiling surface part and intersecting the two or more first grooves. According to this configuration, since the first and second grooves, which extend in different directions, intersect each other, it is possible to more efficiently supply the liquid-phase refrigerant in the extension direction of the grooves as compared with a structure in which line-shaped grooves are arranged in parallel, for example. Consequently, it is possible to more effectively prevent occurrence of localized dryout in the grooves.

In this configuration, it is preferable that the boiler includes a communication part through which the refrigerant flows between the boiler and the condenser; that the first direction is a direction from the boiling surface part toward the communication part side in the boiler; and that a number of the first grooves is greater than a number of the second grooves. According to this configuration, a flow direction of the refrigerant in circulation of the refrigerant between the boiler and the condenser can agree with the first direction, which is an extension direction of the first grooves the number of which is greater. In other words, since the liquid-phase refrigerant returning from the condenser to the boiler flows into the boiler from the communication part and moves through the boiler to a position of the boiling surface part, a flow of the liquid-phase refrigerant is formed roughly in the same direction as the first direction. The liquid-phase refrigerant can be more effectively supplied into the first grooves by providing a greater number of first grooves as main grooves in the flow direction of the liquid-phase refrigerant. Consequently, it is possible to further effectively prevent occurrence of localized dryout in the grooves.

In the first aspect of the present invention, it is preferable that the boiling surface part includes a plurality of first regions in which the groove(s) is/are formed, and a second region(s) arranged between the plurality of first regions having no groove. According to this configuration, it is possible to provide the boiling surface part with the first regions in which generation efficiency of bubbles is relatively high, and a second region(s) in which generation efficiency of bubbles is relatively low and a large amount of liquid-phase refrigerant exists between the first regions. Consequently, for example, even under conditions in which heat flux is large and dryout is likely to occur in the grooves formed in the first regions, it is possible to provide an effect of supplying the liquid-phase refrigerant from the second region(s) to the first regions. As a result, it is possible to prevent occurrence of dryout in the grooves.

In this configuration, it is preferable that the plurality of first regions and a plurality of second regions as the second regions are alternately arranged in the boiling surface part; and that each of the plurality of first regions is formed in a stepped shape shifted with respect to the second region adjacent to the first region in a thickness direction of the boiling surface part. According to this configuration, a relatively large groove-shaped or hole-shaped first structure is formed on the boiling surface part by the first and second regions adjacent to each other, while a relatively small groove-shaped second structure is formed on surfaces of the first regions in the first structure by the grooves. Consequently, a heat transfer area (a surface area in contact with the liquid-phase refrigerant) of the boiling surface part can be large as compared with a case in which only the second structure (grooves) is provided on the flat boiling surface part.

In the first aspect of the present invention, it is preferable that the groove(s) has/have a maximum opening width not smaller than 1 µm and smaller than 1 mm. According to this configuration, it is possible to provide the grooves whose size is suitable for serving as the starting point of nucleate boiling in the liquid-phase refrigerant. Consequently, it is possible to effectively improve the generation rate of bubbles on the boiling surface part.

A method for producing a boiling cooler according to a second aspect of the present invention is a method for producing a boiling cooler including a boiler boiling a refrigerant by transferring heat from a heat source, and a condenser condensing the refrigerant vaporized in the boiler and returning the condensed refrigerant to the boiler, the method including forming the condenser; and forming the boiler including a mounting surface on which the heat source is mounted, and a boiling surface part on a surface that is opposite to the mounting surface and is in contact with the refrigerant, wherein the forming the boiler includes forming on the boiling surface part a groove(s) that has/have an irregularly protruding/recessed shape shaped by melting and solidification of a material by energy beam processing by applying groove formation processing by irradiating the boiling surface part with an energy beam in a line-shaped pattern.

In the method for producing a boiling cooler according to the second aspect of the present invention, as discussed above, the forming the boiler includes forming on the boiling surface part a groove(s) that has/have an irregularly protruding/recessed shape shaped by melting and solidification of a material by energy beam processing by applying groove formation processing by irradiating the boiling surface part with an energy beam in a line-shaped pattern. Accordingly, the groove(s) having the irregularly protruding/recessed shape and formed on the boiling surface part serves/serve as a starting point of nucleate boiling, and improves/improve a generation rate of bubbles. Also, since the protruding/recessed shape is not a hole whose perimeter is closed but a groove extending in a line shape, no wall is formed at least an extension direction of the groove(s) so that the liquid-phase refrigerant can flow through the groove(s). In other words, since a pair of interior surfaces are formed in a width direction of the groove(s), the generation rate of bubbles can be increased by securing a large heat transfer area to the liquid-phase refrigerant; and since no interior surfaces are formed in the extension direction of the groove(s), the liquid-phase refrigerant can be smoothly supplied from the outside of the groove(s) into the groove(s) when the bubbles generated leave the groove(s). Consequently, it is possible to prevent occurrence of localized dryout while increasing the generation rate of bubbles on the boiling surface part by forming protrusions/recesses.

### Effect of the Invention

According to the present invention, as discussed above, it is possible to prevent occurrence of localized dryout while increasing a generation rate of bubbles on a boiling surface part by forming protrusions/recesses.

### Brief Description of the Drawings

FIG. 1 is a schematic perspective view showing a boiling cooler according to a first embodiment.
FIG. 2 is a schematic exploded perspective view showing the boiling cooler according to the first embodiment.
FIG. 3 is a longitudinal cross-sectional view showing the boiling cooler according to the first embodiment.
FIG. 4 is a schematic plan view showing a boiling surface part according to a first example.
FIG. 5 is a schematic plan view of a boiler illustrating a position the boiling surface part and an orientation of grooves.
FIG. 6(A) is a schematic cross-sectional view showing an imaginary processing image of grooves in the first example, and FIG. 6(B) is a schematic cross-sectional view of the grooves in the first example that are actually formed.
FIG. 7 is a schematic view illustrating formation of protrusions/recesses by energy beam processing.
FIG. 8(A) is a schematic cross-sectional view of grooves in a second example, and FIG. 8(B) is a schematic cross-sectional view of grooves in a modified example.
FIG. 9(A) is a plan view of grooves in a third example, FIG. 9(B) is a schematic cross-sectional view of the grooves in the third example, FIG. 9(C) is a plan view of grooves in a modified example of the third example, and FIG. 9(D) is a schematic cross-sectional view of the grooves in the modified example of the third example.
FIG. 10(A) is a plan view of a hole of a comparative example, FIG. 10(B) is a P-P cross-sectional view illustrating the hole, FIG. 10(C) is a Q-Q cross-sectional view illustrating the hole, FIG. 10(D) is a plan view of a groove according to the first embodiment, FIG. 10(E) is a P-P cross-sectional view illustrating the groove according to the first embodiment, and FIG. 10(F) is a Q-Q cross-sectional view illustrating the groove according to the first embodiment.
FIG. 11 is a view illustrating a process forming a condenser.
FIG. 12 is a view illustrating a process forming the boiler.
FIG. 13 is a view illustrating a process joining the boiler to the condenser and attachment of a heat source onto a mounting surface.
FIG. 14 is a view illustrating a formation pattern of grooves according to a first modified example.
FIG. 15 is a view illustrating a formation pattern of grooves according to a second modified example.
FIG. 16 is a schematic exploded perspective view showing a boiling cooler according to a first modified embodiment of the first embodiment.
FIG. 17 is a schematic exploded perspective view showing a boiling cooler according to a second modified embodiment of the first embodiment.
FIG. 18 is a schematic perspective view showing a boiling cooler according to a second embodiment.
FIG. 19 is a schematic exploded perspective view (1) showing a boiler of the boiling cooler according to the second embodiment.
FIG. 20 is a schematic exploded perspective view (2) showing the boiler of the boiling cooler according to the second embodiment.
FIG. 21 is a view illustrating mounting of a mount to a boiler main body in the boiling cooler according to the second embodiment.
FIG. 22 is a view illustrating mounting of a condenser to the boiler in the boiling cooler according to the second embodiment.
FIG. 23 is a perspective view showing the boiling cooler with the heat source mounted according to the second embodiment.
FIG. 24 is a schematic exploded perspective view showing a boiler of a boiling cooler according to a first modified embodiment of the second embodiment.
FIG. 25 is a schematic exploded perspective view showing a boiler of a boiling cooler according to a second modified embodiment of the second embodiment.

### Modes for Carrying Out the Invention

The following description will describe embodiments according to the present invention with reference to the drawings.

### [First Embodiment]

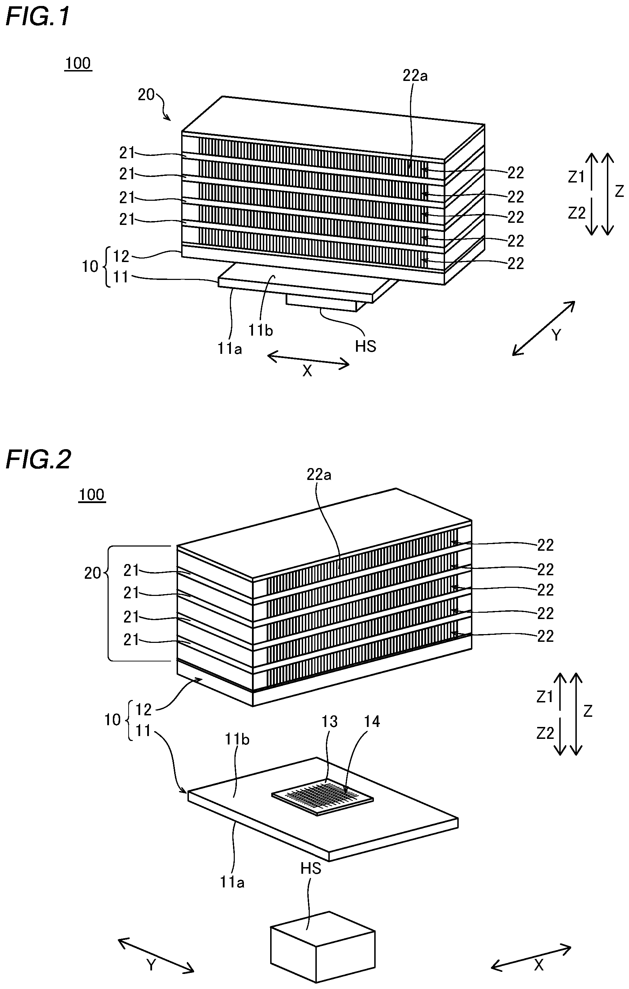

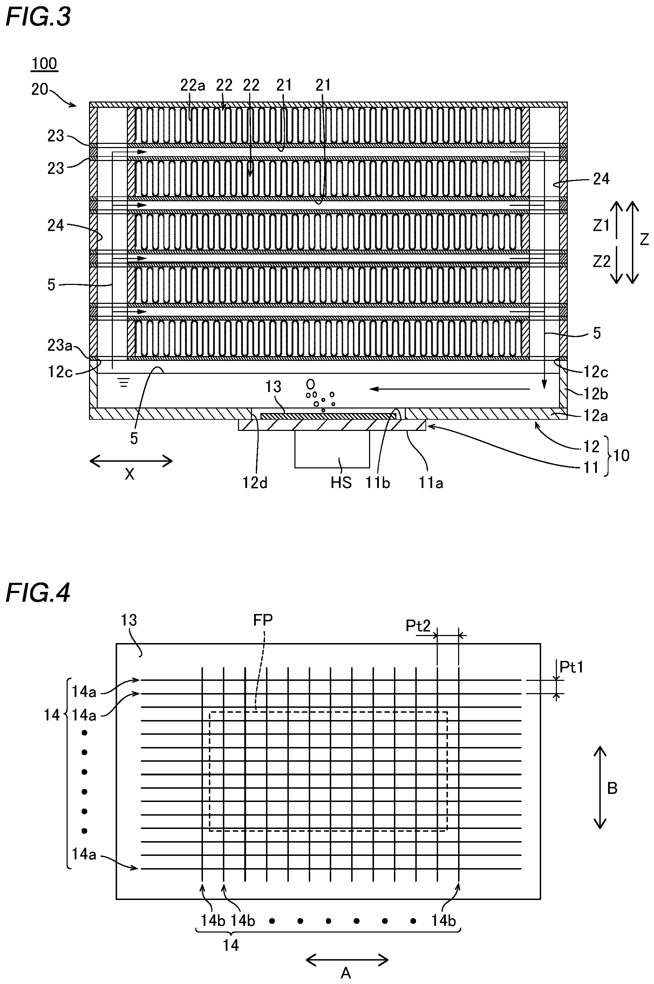

A configuration of a boiling cooler 100 (hereinafter, referred to as cooler 100) according to a first embodiment is now described with reference to FIGS. 1 to 9. The cooler 100 is a cooler using a boiling cooling method, which absorbs heat from a heat source HS and dissipates the heat to the outside using phase change (latent heat) in vaporization and condensation of a refrigerant 5 (see FIG. 3). The heat source HS is, for example, a CPU (central processing unit). The heat source HS is not limited to any particular device. The refrigerant 5 is, for example, fluorocarbons, hydrocarbons, or water. The refrigerant 5 is not limited to any particular refrigerant.

Two directions substantially perpendicular to each other in a horizontal plane are defined as X and Y directions. An upward/downward direction substantially perpendicular to the horizontal plane (X-Y plane) is referred to as a Z direction. Here, the Z direction is parallel to a direction of gravity, and the gravity is applied in the downward direction.

As shown in FIGS. 1 to 3, the cooler 100 includes a boiler 10 and a condenser 20. The boiler 10 boils the refrigerant 5 (see FIG. 3) by transferring heat from the heat source HS. The condenser 20 condenses the refrigerant 5 vaporized in the boiler 10 and returns the vaporized refrigerant to the boiler 10. The boiler 10 and the condenser 20 have airtight interior spaces that communicate with each other and accommodate the refrigerant 5 in the interior spaces. In the first embodiment, the boiler 10 and the condenser 20 are formed as an integrated unit. In other words, the boiler 10 and the condenser 20 are adjacent to (in contact with) each other.

The boiler 10 includes the mount 11 and a reservoir 12 (see FIG. 3). The mount 11 has a flat plate shape extending in horizontal directions. Also, a lower-side (Z2-direction side) surface of the mount 11 serves as a mounting surface 11a onto which the heat source HS is mounted. The mount 11 includes a boiling surface part 13 on an upper-side (Z1-direction side) surface 11b opposite to the mounting surface 11a. The reservoir 12 accommodates the refrigerant 5 in a liquid phase. As shown in FIG. 3, the reservoir 12 is a recessed part that has a bottom 12a and a peripheral wall 12b, and is recessed downward (Z2 direction). The reservoir 12 has a top surface joined to a bottom surface of the condenser 20. The bottom 12a has a window 12d, and the window 12d is closed by the mount 11. The boiling surface part 13 is arranged on the surface 11b of the mount 11 to be held in the window 12d. The boiling surface part 13 is in contact with the liquid-phase refrigerant 5 in the reservoir 12. The boiling surface part 13 will be described in detail later.

The condenser 20 is configured as a plate-fin type heat exchanger. The condenser 20 includes one or more refrigerant flow paths 21 and one or more external flow paths 22. In the exemplary cooler shown in FIGS. 1 to 3, four refrigerant flow paths 21 and five external flow paths 22 are provided in the condenser 20. As shown in FIG. 3, the refrigerant flow paths 21 and the external flow paths 22 are alternately arranged to interpose partition plates 23 between the refrigerant and external flow paths in the Z direction. Each refrigerant flow path 21 is a hollow plate-shaped space extending in the X direction and forms a part of a closed interior space of the cooler 100. The refrigerant flow paths 21 are flow paths through which the refrigerant 5 flows. Corrugated fins (not shown) are arranged to extend in the X direction inside the refrigerant flow paths 21.

The external flow paths 22 are flow paths through which an external fluid flows. The external fluid is a fluid for cooling the refrigerant 5, for example, air. The external fluid is not limited to any particular fluid. The external flow paths 22 (see FIG. 1) are opened toward the outside. The external flow paths 22 communicates to neither the refrigerant flow paths 21 nor the boiler 10 (reservoir 12). The external flow paths 22 are formed to pass through the cooler 100 in the Y direction. Corrugated fins 22a are arranged to extend in the Y direction in the external flow paths 22.

As shown in FIG. 3, the condenser 20 includes connection paths 24 connecting the refrigerant flow path 21 and the boiler 10 to each other. The four refrigerant flow paths 21 communicate with the reservoir 12 of the boiler 10 through the connection paths 24 extending in the Z direction. Each connection path 24 is a path (branch path) having one end connected to a communication part 12c of the boiler 10 and formed to be connected to end openings of the refrigerant flow paths 21 on an X-direction side. The connection paths (two connection paths) 24 are arranged on one end and another end of the refrigerant flow path 21 in the X direction. One of the connection paths 24 serves to supply the vapor-phase refrigerant 5 vaporized in the boiler 10 to the refrigerant flow paths 21 from the boiler 10, and another connection path 24 serves to supply the liquid-phase refrigerant 5 condensed in the refrigerant flow paths 21 from the condenser 20 to the boiler 10. The communication parts 12c of the boiler 10 are a connection inlet and a connection outlet (openings) through which the refrigerant 5 flows between the boiler 10 and the condenser 20. The communication parts 12c are formed in a partition plate 23a separating the reservoir 12 and the condenser 20 from each other. The communication parts 12c corresponding to connection paths (two connection paths) 24 are arranged in one end part and another end part of the boiler 10 in the X direction.

When the heat from the heat source HS is transferred to the boiling surface part 13 through the mount 11, the liquid-phase refrigerant 5 reserved in the reservoir 12 is heated and boiled. The vapor-phase refrigerant 5, which has vaporized as a result of boiling, moves into the refrigerant flow paths 21 through one of the communication parts 12c and one of the connection paths 24 (on the left side in FIG. 3). The vapor-phase refrigerant 5 is cooled and condensed in the refrigerant flow paths 21 by heat exchange with the external fluid flowing the external flow paths 22 adjacent to the refrigerant flow paths. The condensed liquid-phase refrigerant 5 moves through the refrigerant flow paths 21 and returns to the reservoir 12 through another of the connection paths 24 and another of the communication parts 12c (on the right side in FIG. 3). Accordingly, the refrigerant 5 enclosed in the cooler 100 is circulated between the boiler 10 and the condenser 20 by heat input from the heat source HS. As the refrigerant 5 circulates, the heat source HS is cooled.

### (Configuration of Boiling Surface Part)

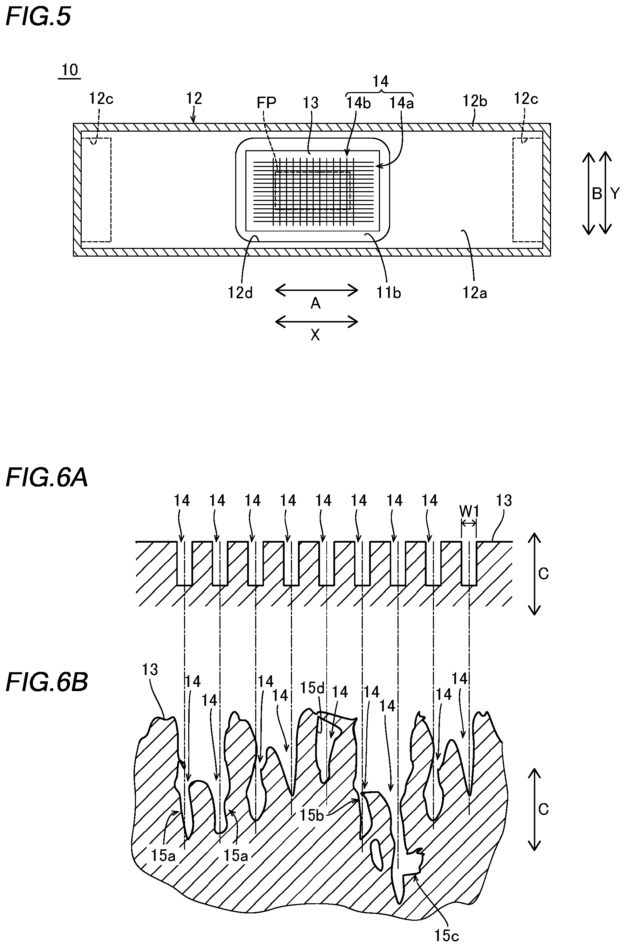

Here, in the first embodiment, the boiling surface part 13 has grooves 14 extending in a line shape, as shown in FIG. 2. Also, the grooves 14 have irregularly protruding/recessed shapes (see FIG. 6(B)) shaped by melting and solidification of a material by energy beam processing. The grooves 14 have main functions of (1) increasing a heat transfer area (a surface area in contact with the refrigerant 5) in the boiling surface part 13, (2) providing protrusions/recesses serving as the starting point of nucleate boiling of the refrigerant 5, and (3) serving as flow paths of the refrigerant 5 to supply the new liquid-phase refrigerant 5 to escape points at which bubbles generated in the groove 14 escape from the grooves 14. Here, the grooves 14 are recessed non-through grooves that are opened on the boiling surface part 13 side and have bottoms. The grooves 14 are line-shaped recessed parts that have a length along the boiling surface part 13 greater than a depth with respect to the boiling surface part 13.

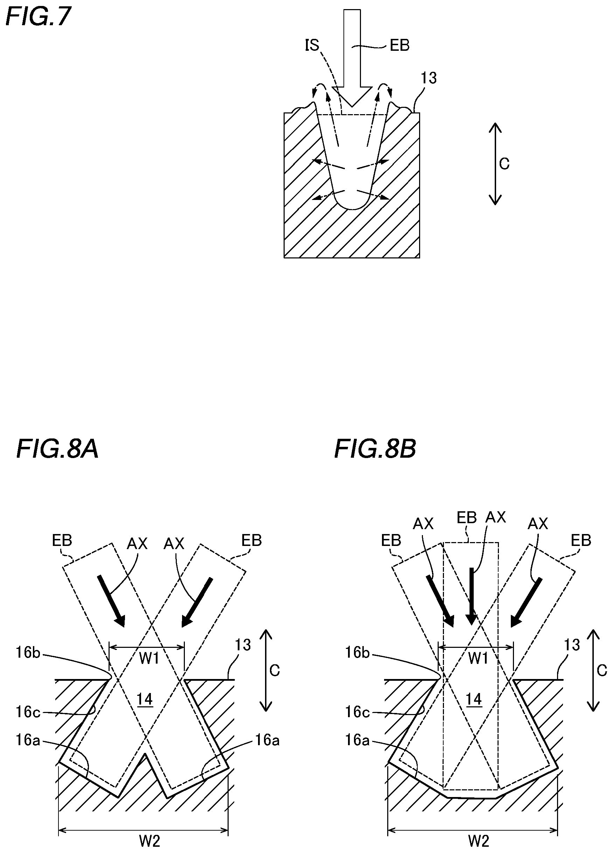

In the first embodiment, the boiling surface part 13 is integrally formed on the surface 11b of the mount 11. In the exemplary cooler shown in FIG. 2, the boiling surface part 13 is a flat surface part formed to protrude one step from the surface 11b. The grooves 14 are formed by applying energy beam processing onto the boiling surface part 13. The energy beam processing is a process irradiating the boiling surface part 13 with an energy beam EB (see FIG. 7) in a line-shaped pattern as a grooving process. The energy beam EB with which the boiling surface part is irradiated is, for example, a laser beam (laser light).

Although a material of the boiling surface part 13 is not limited to a particular material, the material can be, for example, an aluminum material. The aluminum material is suitable as a material for the boiling surface part 13 because of its high thermal conductivity, and is suitable for weight reduction the of the cooler 100 because of its light weight. Here, the aluminum material is a concept including pure aluminum and aluminum alloys.

An exemplary configuration of the boiling surface part 13 is described with reference to FIGS. 4 to 9. In the following, the two directions in the plane parallel to the boiling surface part 13 that are perpendicular to each other are defined as directions A and B. A direction perpendicular to the boiling surface part 13 (a thickness direction of the boiling surface part 13) defined as a direction C. As an exemplary arrangement, in the first embodiment, the direction A coincides with the X direction, and the direction B with coincides the Y direction. In the first embodiment, the direction C coincides with the Z direction. Here, the direction A and the direction B are examples of a "first direction" and a "second direction" in the claims, respectively.

### (Formation Area, Orientation and Arrangement of Grooves)

In the exemplary boiling surface part shown in FIG. 4, the grooves 14 are formed in a predetermined area on the boiling surface part 13. The predetermined area includes at least a part of a region FP overlapping an installation area of the heat source HS (see FIG. 3) on the mounting surface 11a in a thickness direction of the mount 11. The region FP has a projected shape of a footprint of the heat source HS on the mounting surface 11a of the mount 11 projected onto the boiling surface part 13 in the thickness direction of the mount 11 (Z direction). In FIG. 4, the predetermined area is an area that encompasses the region FP and is larger than the region FP.

The grooves 14 are formed on the entire region FP. For example, if the grooves 14 formed in the entire region FP are extracted, and a closed graphic object enclosing the extracted grooves 14 with an envelope is assumed, the graphic object has an area of not smaller 80% of the area of the region FP. In the exemplary boiling surface part shown in FIG. 4, the grooves 14 extend across from one of outer edges to another outer edge of the region FP. The grooves 14 extend over the outside of the region FP and the inside of the region FP.

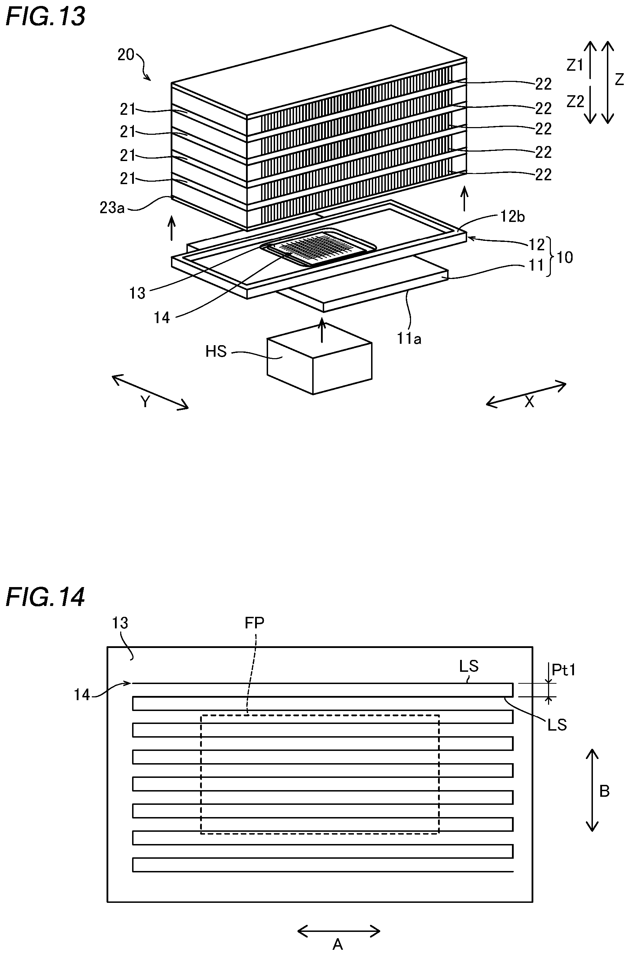

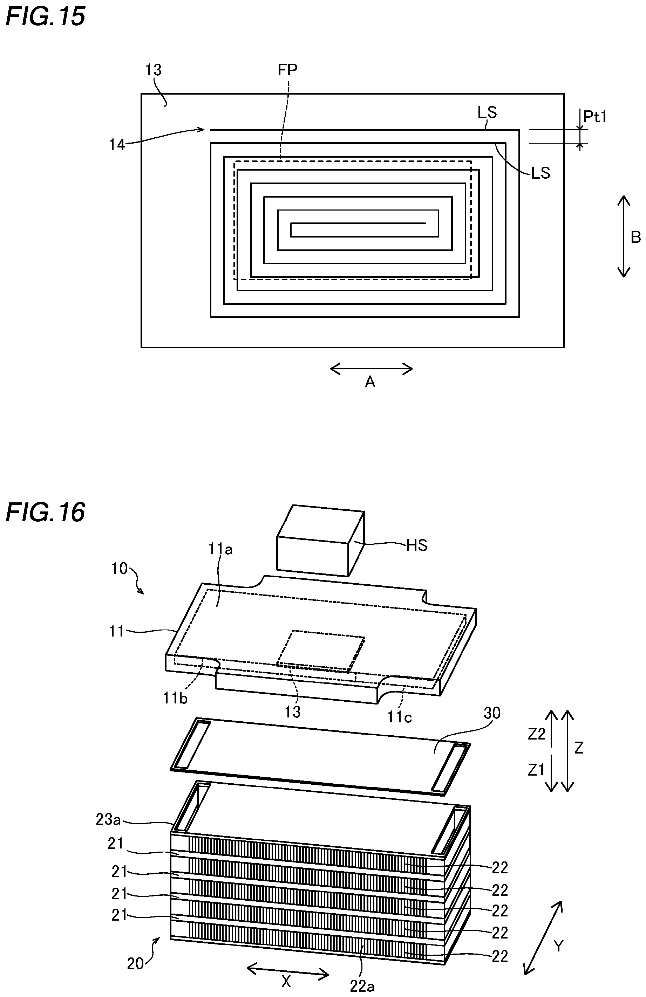

In the boiling surface part 13, one or more grooves 14 are formed. The grooves 14 may be formed over the entire region FP by bending a single groove 14, as in a single stroke (see FIGS. 14 and 15), or may be formed over the entire region FP by an array of a plurality of separate grooves 14 (see FIG. 4). In a case in which the plurality of grooves 14 are provided as in FIG. 4, not smaller than ten, not smaller than one hundred or not smaller than one thousand the grooves 14 are formed in the region FP. Here, only a very small part of a number of grooves 14 are schematically shown for illustration of a schematic pattern of the plurality of grooves 14 in FIGS. 4 and 5. The plurality of grooves 14 can actually be formed at a higher density than the grooves shown in FIGS. 4 and 5. For example, in a plan view, the total area of the grooves 14 in the region FP is not smaller than 30%, preferably not smaller than 50%, more preferably not smaller than 70% of the total area of a non-grooved part (part on which no grooves 14 are formed ) in the region FP.

A pitch of the plurality of grooves 14 is not greater than 1 mm, preferably greater than 500 µm, and more preferably greater than 200 µm. The reason is that the smaller the pitch, the greater the number of grooves 14 provided, and the heat transfer area (surface area) of the boiling surface part 13 can be increased. Even in a case in which a single groove 14 is provided (see FIGS. 14 and 15), the above pitch can be applied to intervals between line segments LS of the single groove 14 adjacent to each other.

The maximum opening width of the groove 14 (i.e., the maximum groove width in the plan view) is not greater than 1 mm, preferably greater than 500 µm, and more preferably greater than 200 µm. The reason is that a groove width suitable for the starting point of nucleate boiling of the liquid-phase refrigerant 5 falls within a range from several µm to several hundred µm. The maximum opening width of the groove 14 is not smaller than 1 µm, for example, not smaller than 10 µm. The reason is that, if the groove width is smaller than 1 µm, the groove width is too small to serve as the starting point of nucleate boiling of the refrigerant 5. The groove 14 preferably has a maximum opening width not smaller than 1 µm and smaller than 1 mm.

### (Grooves in First Example)

In the grooves 14 in a first example shown in FIG. 4, a plurality of grooves 14 are formed on the boiling surface part 13. Each of the plurality of grooves 14 extends in a straight-line shape.

In FIG. 4, the plurality of grooves 14 includes two or more first grooves 14a and two or more second grooves 14b. The two or more first grooves 14a extend in the first direction (direction A) along the boiling surface part 13. The two or more second grooves 14b extend in the second direction (B direction) different from the first direction (direction A) along the boiling surface part 13 and intersect the two or more first grooves 14a. In FIG. 4, the two or more first grooves 14a extend in the direction A and are aligned with each other in the direction B. The two or more second grooves 14b extend in the direction B and are aligned with each other in the direction A. The first direction (direction A) and the second direction (direction B) are perpendicular to each other.

In the first embodiment, the first direction (direction A) is a direction from the boiling surface part 13 toward the communication part 12c side in the boiler 10. As described above, in the first embodiment, the direction A coincides with the X direction. As shown in FIG. 5, in the X direction, the boiling surface part 13 is arranged in a substantially center of the boiler 10, and the communication parts 12c (see FIG. 3) are arranged on both ends of the boiler 10 in the X direction. Accordingly, the direction from the boiling surface part 13 to the communication part 12c side is in the X direction (direction A). In other words, the two or more first grooves 14a extend in a flow direction of the liquid-phase refrigerant 5 moving from the communication part 12c to the boiling surface part 13. Also, the number of the first grooves 14a is greater than the number of the second grooves 14b. Consequently, the two or more first grooves 14a serve as a primary path through which the refrigerant 5 flows in the X direction (direction A) extending in the flow direction of the refrigerant 5 in the boiler 10, and the two or more second grooves 14b serve as a secondary path through which the refrigerant 5 flows from lateral sides into the first grooves 14a.

In FIG. 4, the two or more first grooves 14a are aligned at a constant pitch Pt1, and the two or more second grooves 14b are aligned at a constant pitch Pt2. Also, the pitch Pt2 is specified to be greater than the pitch Pt1. Parts of the boiling surface part 13 between the plurality of grooves 14 (the first grooves 14a and the second grooves 14b) are flat surfaces to which no grooving is applied.

Cross-sectional shapes of the grooves 14 in the first example are shown in FIG. 6. FIG. 6(A) is a schematic conceptual view (imaginary processing image) of energy beam processing applied to the boiling surface part 13, and FIG. 6(B) is a schematic view of the cross-sectional shape of the grooves 14 formed on the boiling surface part 13 as a result of energy beam processing in the first embodiment.

As shown in FIG. 6(A), the boiling surface part 13 is irradiated (scanned) with the energy beam EB (see FIG. 7) having a predetermined spot diameter at a predetermined pitch in a line shape so that grooving is applied to the boiling surface part 13. Here, as shown in FIG. 7, when an original surface IS (a surface before the grooves 14 are formed) of the boiling surface part 13 is irradiated with the energy beam EB, a material (base material) forming the boiling surface part 13 absorbs energy of the energy beam EB so that heat is rapidly generated in the material. Accordingly, the material whose temperature rises to its melting point melts and/or evaporates, and is scattered from an irradiation point of the energy beam EB so that the material is removed from the original surface IS. Double-dot dashed arrows in FIG. 7 represent situations of expansion, scattering and deposition of the material. Consequently, a groove-shaped recessed part is formed in the boiling surface part 13, but parts of the scattered material is cooled and deposited in proximity to the recessed part. Also, since the material that melts/evaporates in the irradiation with energy beam EB is scattered with rapid expansion, irregular and very small protrusions/recesses are formed on an interior surface of the recessed part.

As a result of these situations, after energy beam processing the grooves 14 formed in the boiling surface part 13 have an irregularly protruding/recessed shape as shown in FIG. 6(B) based on a groove pattern shown in FIG. 6(A). As shown in this FIG. 6(B), each of the grooves 14 formed in the boiling surface part 13 has the irregularly protruding/recessed shape shaped by melting and solidification of a material by energy beam processing.

Here, in general energy beam processing (e.g., laser precision processing), such irregularly protruding/recessed shapes described above are considered as an indication of low processing accuracy, and irradiation conditions (energy density, irradiation time (pulse width), and the like) of the energy beam EB are optimized to reduce protruding/recessed shapes to a minimum. For this reason, in general energy beam processing, machined surfaces whose protrusions/recesses are reduced as uniform as possible are formed. Contrary to this, irregularly protruding/recessed shapes are formed in the grooves 14 according to the first embodiment by using irradiation conditions to actively form protrusions/recesses different from those of an energy beam EB that are optimized in general energy beam processing. In particular, the boiling surface part is irradiated with the energy beam EB at an energy density that is generally considered excessive to form the grooves 14 having the irregularly protruding/recessed shape as shown in FIG. 6(B). Also, in particular, in a case of irradiation with an energy beam EB having high energy at short pulses, ablation is generated in the material. Ablation is a phenomenon in which a surface of a material is instantaneously decomposed and explosively evaporates when high energy is applied to an irradiated area in a very short period of time. Protrusions/recesses can be effectively formed on a surface of part subject to processing by generating ablation. Energy beam processing generating such ablation may be used to form the grooves 14.

In the exemplary shapes shown in FIG. 6(B), the groove 14 includes a spaces 15a to 15d formed of at least one of a hole opened in the boiling surface part 13, a hollow with at least a part of an opened part of the hole being covered, a lateral hole extending laterally from the hole or the hollow, and a tunnel-shaped pathway with a part of an opening in the groove 14 being covered.

The space 15a that has a hole opened in the boiling surface part 13 is a part of the interior surface of the groove 14 that is a localized hole (recess) whose perimeter is closed and whose upper end is free (opened). The space 15b that has a hollow is a part that is a hole which is formed by the energy beam EB resulting from deposition of the material scattered by irradiation with the energy beam EB and whose opening is partially or entirely covered. The space 15b is a hollow space that has a smaller opening a compared with the maximum width of the interior space or no opening. The space 15c that has a lateral hole is a space that is recessed toward a lateral side, which is different from a depth direction of the groove 14 (i.e., an irradiation direction of the energy beam EB), resulting from rapid expansion or the like of the material caused by the irradiation with the energy beam EB. Also, a shape whose opening is covered due to deposition of scattered material or the like such as the space 15b may be formed in an opening of the groove 14. In such a shape, the groove 14 includes a space 15d formed by the tunnel-shaped pathway with a part of its opening extending in an extension direction of the groove 14 being covered. The "irregularly" protruding/recessed shape formed by irradiation with the energy beam EB refers to a shape that includes at least one of these spaces 15a to 15d.

These spaces 15a to 15d are structures partially formed in parts of the grooves 14. In other words, the spaces 15a to 15d are parts of the grooves 14 (components forming the irregularly protruding/recessed shape) and are substructures smaller than the main structures as the grooves 14. Such localized protrusions/recesses are suitable for starting points of nucleate boiling of the refrigerant 5.

### (Grooves in Second Example)

The groove 14 in a second example is shown in FIG. 8. In the second example, a part of the groove 14 has a bottom 16a that is wider than an opening width W1 of the groove 14 in a cross section perpendicular to an extension direction of the groove 14. In other words, the groove 14 is formed to have a width W2 of the bottom 16a of the groove 14 greater than the opening width W1 of the groove 14 on the main surface of the boiling surface part 13. Here, FIG. 8 is a conceptual view (imaginary processing image) of energy beam processing similar to FIG. 6(A) without the grooves 14 having irregularly protruding/recessed shape being illustrated.

The groove 14 that has the wide bottom 16a is formed, for example, by irradiating a common spot on the boiling surface part 13 with energy beams EB whose optical axes AX are inclined at different orientations. In other words, the groove 14 is formed by irradiating (scanning) the common spot on the boiling surface part 13 with the energy beams EB on a plurality of paths with the optical axes AX of the energy beams EB on the paths being inclined with respect to a direction normal to the main surface of the boiling surface part 13.

In FIG. 8(A), one groove 14 is formed by irradiating the common spot on the boiling surface part 13 with a first energy beam EB whose optical axis AX is inclined toward one side and a second energy beam EB whose optical axis AX is inclined toward another side as viewed in a cross section perpendicular to the extension direction of the groove 14. Since the paths of the energy beams EB (dashed lines) pass through the spot on the main surface of the boiling surface part 13 in which the paths overlap each other, a relatively narrow opening 16b is formed in the groove 14. Since the paths of the energy beams EB are inclined to be apart from each other in a depth direction after passing through the main surface, the bottom 16a that expands outward from the opening 16b.

In FIG. 8(B), one groove 14 is formed by irradiating the common point on the boiling surface part 13 with the first energy beam EB whose optical axis is inclined toward one side, the second energy beam EB whose optical axis is inclined toward another side as in a cross section perpendicular to the extension direction and a third energy beam EB whose optical axis is not inclined but extends in the normal direction as viewed in a cross section perpendicular to the extension direction. The third energy beam EB removes the material in a part directly below an intersection (opening 16b) of the path of the first energy beam EB and the path of the second energy beam EB. Consequently, the groove 14 that has a sector shape expand downward from the opening 16b in a cross sectional shape.

### (Grooves in Third Example)

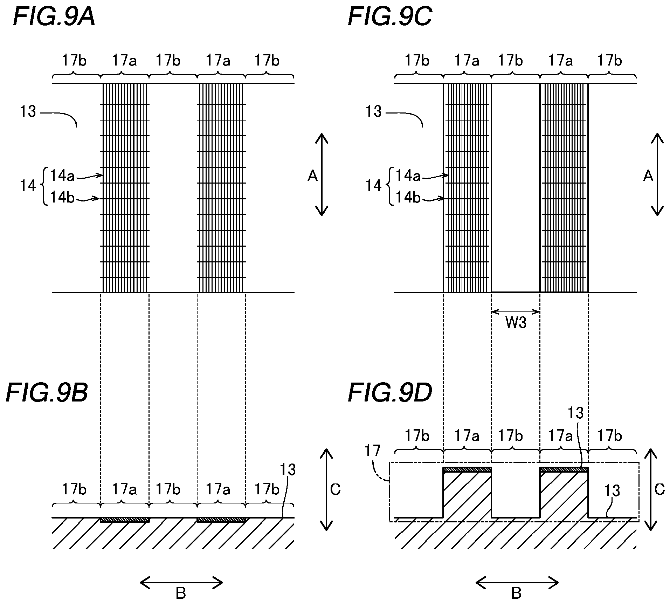

The grooves 14 in a third example are shown in FIG. 9. In the third example, the boiling surface part 13 includes a plurality of first regions 17a on which the grooves 14 are formed, and second regions 17b which are arranged between the plurality of first regions 17a and on which no grooves 14 are formed. Both the first regions 17a and the second regions 17b are arranged at least in the region FP (see FIG. 4), which overlaps the installation area of the heat source HS, and may extend outside the region FP.

The groove 14 is formed on substantially the entire first region 17a, for example. For example, a plurality of grooves 14 (the first grooves 14a and the second grooves 14b) are formed at a predetermined pitch in the first region 17a. The second region 17b is a flat surface on which no grooves 14 are formed.

In FIGS. 9(A) and 9(B), the first regions 17a and the second regions 17b extend in a straight-line shape in the boiling surface part 13, respectively. A plurality of first regions 17a and a plurality of second regions 17b are arranged alternately side by side in the boiling surface part 13.

In FIGS. 9(A) and 9(B), the main surface of the boiling surface part 13 is formed as a flat surface, and the first region 17a and the second region 17b are formed on the flat main surface.

In FIGS. 9(C) and 9(D), the plurality of first regions 17a are formed in stepped shapes shifted in the thickness direction (direction C) of the boiling surface part 13 with respect to the second regions 17b adjacent to the first regions. In other words, in the example shown in FIGS. 9(C) and 9(D), a groove-shaped structure 17 having the first regions 17a as tops of the protruding parts and the second regions 17b as bottoms of the recessed parts is formed on the main surface of the boiling surface part 13. The first regions 17a form steps shifted to protrude in the thickness direction with respect to the second region 17b adjacent to the first regions. Also, the grooves 14 (the first grooves 14a and the second grooves 14b) are formed in the first regions 17a, which form the tops of the protruding parts. Accordingly, in the examples shown in FIGS. 9(C) and 9(D), a relatively large (macro) groove-shaped structure 17 formed of the first region 17a and the second region 17b, and a relatively small (micro) grooves 14 formed in the first regions 17a, which are parts of the groove-shaped structure 17, are formed on the boiling surface part 13. A groove width W3 (i.e., a width of the second region 17b) in the groove-shaped structure 17 is greater than the opening width W1 of the groove 14 (see FIG. 6(A)). The opening width W1 of the groove 14 is not greater than 1 mm, while the groove width W3 of the groove-shaped structure 17 is greater than 1 mm, for example, not smaller than 2 mm and not greater than 5 mm. Here, in FIGS. 9(C) and 9(D), a width of the first region 17a is equal to the groove width W3 (i.e., a width of the second region 17b).

### (Working Effect of Grooves)

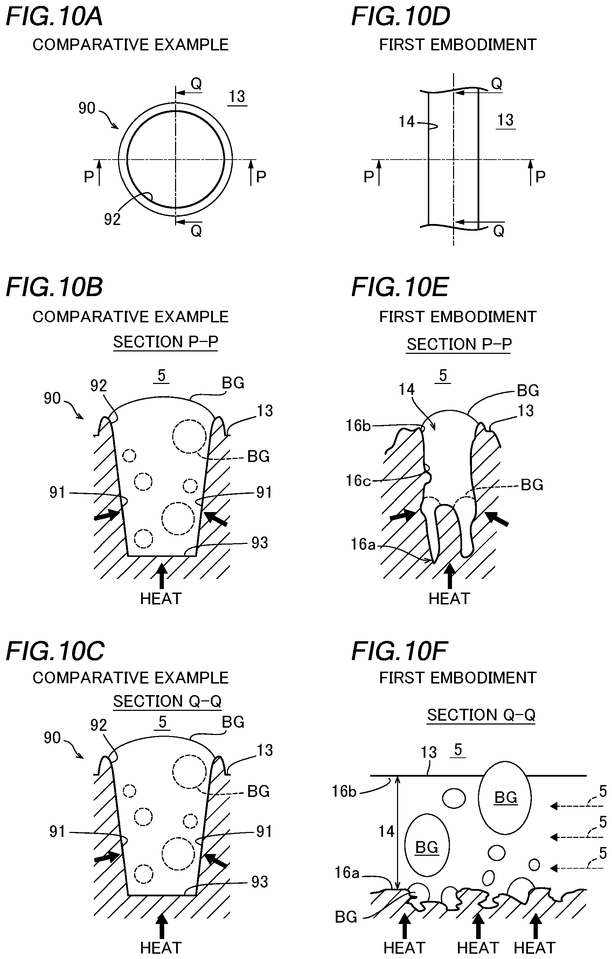

Working effects of the grooves 14 formed on the boiling surface part 13 are described with reference to FIG. 10.

Simply speaking, nucleate boiling on the heat transfer surface (boiling surface part 13) is a phenomenon in which evaporation of the refrigerant 5 on the heat transfer surface, formation of bubbles, escape of bubbles from the heat transfer surface, and supply of the liquid-phase refrigerant 5 to the heat transfer surface are repeated. Even on a flat heat-transfer surface, very small scratches and holes can be the starting points of bubbles (bubble generation points).

FIGS. 10(A) to 10(C) are schematic views showing a boiling model in a comparative example in which a circular hole 90 is formed on the heat transfer surface; FIG. 10(A) is a top view of the circular hole 90; FIG. 10(B) is a P-P cross-sectional view of the circular hole 90; and FIG. 10(C) is a Q-Q cross-sectional view of the circular hole 90. The circular hole 90 has the same cross-sectional shape in the P-P cross-sectional view and the Q-Q cross-sectional view, and an interior space of the circular hole 90 is entirely surrounded by an interior wall 91.

The liquid-phase refrigerant 5 can flow into the circular hole 90 in the comparative example only through its opening 92. In other words, both the escape of the bubbles BG from the circular hole 90 and the supply of the liquid-phase refrigerant 5 to the circular hole 90 take place only through the one opening 92. For this reason, in the comparative example, in a stage in which heat input is small and small bubbles BG (see dashed line) are sparsely formed, the escape of the bubbles BG and the supply of liquid-phase refrigerant 5 can take place in good balance. On the other hand, as the heat input increases and the formation and escape of the bubbles BG intensively take place in the circular hole 90, the bubbles BG interfere with the supply of liquid-phase refrigerant 5 through the opening 92. As a result, large bubbles BG (see solid line) fill up to the opening 92 in the circular hole 90, and the interior of the circular hole 90 will be brought in a dryout state of (film boiling state). Even if the interior wall 91 and the bottom 93 are roughened by energy beam processing, the circumstances in which interference with the supply of the liquid-phase refrigerant 5 into the circular hole 90 cannot be improved.

FIGS. 10(D) to 10(F) are schematic views showing a boiling model of one groove 14 formed on the boiling surface part 13 according to the first embodiment; FIG. 10(D) is a top schematic view of the groove 14; FIG. 10(E) is a P-P cross-sectional view of the groove 14; and FIG. 10(F) is a Q -Q cross-sectional view of the groove 14. Although the groove 14 is surrounded by an interior wall 16c in the P-P cross-sectional view similar to the circular hole 90 (FIG. 10(B)), the groove is not surrounded by the interior wall 16c in the Q-Q cross-sectional view (the groove 14 extends as viewed in the Q-Q cross-sectional view).

The groove 14 according to the first embodiment allows not only the liquid-phase refrigerant 5 to flow into the groove through a part corresponding to opening 16b in the upward/downward direction but also allows the liquid-phase refrigerant 5 to flow into the groove 14 in a direction extending along a Q-Q line (the extension direction of the groove 14) as shown in FIG. 10(F). The bubbles BG generated in the groove 14 escapes from the groove 14 through the opening 16b directly above the bubbles, while the liquid-phase refrigerant 5 can flow in the direction extending along the groove 14 and be supplied to locations in which the bubbles BG escape. In other words, in a case of the groove 14, the path for the escape of the bubbles BG and the path for the supply of the liquid-phase refrigerant 5 can be different.

In the P-P cross-sectional view, since the groove 14 is a narrow space surrounded by a heat transfer surface (interior wall 16c) similar to in the comparative example, heat can be efficiently conducted to the liquid-phase refrigerant 5 in this space. Also, since the groove 14 having irregularly protruding/recessed shape includes a number of starting points of nucleate boiling, the generation rate of bubbles BG (see dashed lines) can be increased as compared with a flat heat transfer surface even under the circumstances in which heat input is low. As the heat input increases and the formation and escape of the bubbles BG intensively take place, the groove 14 may be filled with the bubbles BG (see solid lines) in the P-P cross-sectional view. On the other hand, even in such a case, since no interior wall 16c exists in the Q-Q cross-sectional view so that the liquid-phase refrigerant 5 can flow, the supply of liquid-phase refrigerant 5 with the escape of the bubble BG can smoothly take place. Consequently, in the groove 14 according to the first embodiment, it is possible to prevent occurrence of localized dryout inside the groove 14 as compared with the comparative example.

Also, in the first embodiment, since the first grooves 14a and the second grooves 14b intersect each other (see FIG. 4), no interior wall 16c exists in an intersection between the first grooves 14a and the second grooves 14b as viewed in the P-P cross-sectional view and the Q-Q cross-sectional view. For this reason, the generation rate of bubbles BG is relatively low, and the dryout is less likely to occur in the intersection (in other words, the liquid-phase refrigerant 5 is likely to exist) as compared with other parts in the groove 14. Since the groove 14 includes partial locations in which the liquid-phase refrigerant 5 is more likely to exist as compared with other parts, even in a case in which heat input is large so that the bubbles BG are intensively generated in most parts of the groove 14, it is possible to facilitate continuous supply of the liquid-phase refrigerant 5 in the groove 14. In other words, intersection between the grooves 14 facilitates improvement of a level of limitation of heat input at which dryout occurs.

### (Boiling-Cooler Production Method)

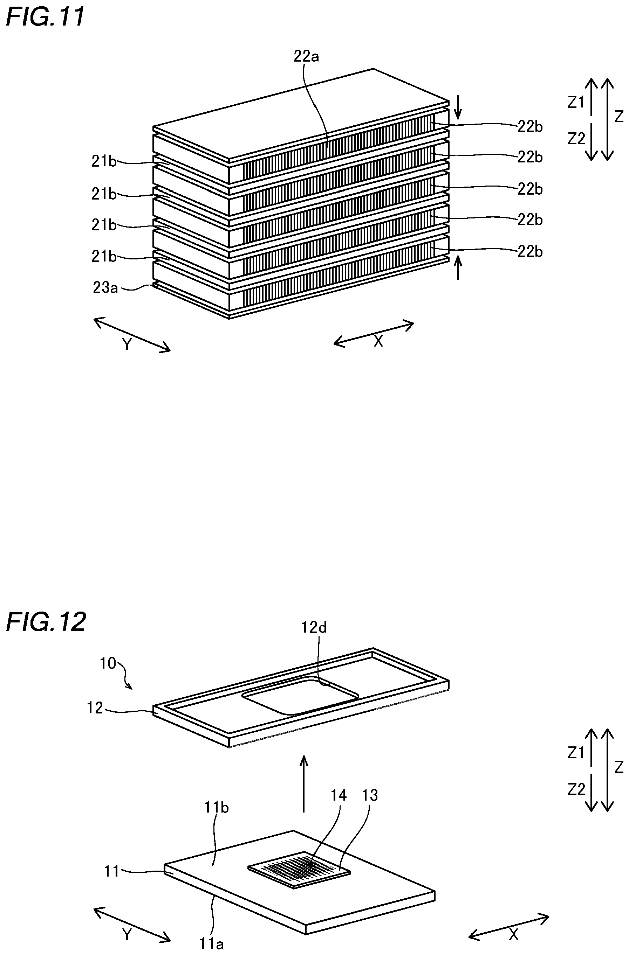

A method for producing the cooler 100 according to the first embodiment is now described with reference to FIGS. 11 to 13. A method for producing the cooler 100 is a method for producing a boiling cooler including a boiler 10 boiling a refrigerant 5 by transferring heat from a heat source HS, and a condenser 20 condensing the refrigerant 5 vaporized in the boiler 10 and returning the condensed refrigerant to the boiler 10.

As shown in FIG. 11, the method for producing the cooler 100 includes forming the condenser 20. The forming the condenser 20 includes forming the condenser 20 by joining refrigerant flow-path elements 21b, which will serve as the refrigerant flow paths 21, to external flow-path elements 22b, which will serve as the external flow paths 22. The joining can be conducted by welding or brazing, for example.

As shown in FIG. 12, the method for producing the cooler 100 includes forming the boiler 10.

Here, in the first embodiment, the forming the boiler 10 includes forming the grooves 14 on the boiling surface part 13 as shown in FIGS. 6 and 7. In other words, in the forming groove 14 on the boiling surface part 13, a grooving process is applied to the boiling surface part by irradiating the boiling surface part 13 with an energy beam EB in a line-shaped pattern. Accordingly, the grooving process forms on the boiling surface part 13 the grooves 14 having irregularly protruding/recessed shapes (see FIG. 6) shaped by melting and solidification of a material by energy beam processing.

In the first embodiment above, two or more first grooves 14a are formed by irradiating the boiling surface part 13 with the energy beam EB in a straight-line-shaped pattern parallel to each other extending in a direction A (see FIG. 4) at a predetermined interval (pitch Pt1). Also, two or more second grooves 14b are formed by irradiating the boiling surface part 13 with the energy beam EB in a straight-line-shaped pattern parallel to each other extending in a direction B (see FIG. 4) at a predetermined interval (pitch Pt2). The irradiation with the energy beam EB can be continuous irradiation or pulsed irradiation (intermittent irradiation). Parameter relating to the irradiation with the energy beam EB is specified to values suitable for forming the grooves 14 having irregularly protruding/recessed shapes as described above. The parameters to be specified include, for example, laser power, an energy density, and a wavelength of laser light in a case in which the energy beam EB is a laser beam. A beam diameter (spot diameter) and a focal point of the energy beam EB are specified in accordance with an opening width W1 of the groove 14 (see FIG. 6).

The boiling surface part can be irradiated with the energy beam EB a plurality of times (with energy beams of a plurality of paths) in the formation of one groove 14. In particular, in the aforementioned second example (see FIG. 8), irradiation of a beam is conducted a plurality of times (a plurality of scans) at different angles of optical axes AX. Also, in the aforementioned third example, energy beam processing (grooving) is selectively applied to predetermined first regions 17a of the boiling surface part 13, while the second regions 17b are excluded from targets of the energy beam processing (grooving). Here, in the aforementioned third example, in a case in which a groove-shaped structure 17 shown in FIGS. 9(C) and 9(D) is provided, the second regions 17b are formed by removing parts between the first regions 17a from the main surface of the boiling surface part 13 by cutting, for example, to form steps.

Also, in a case in which the first regions 17a and the second regions 17b are parallel to each other and have a straight-line shape, the technique for providing the groove-shaped structure 17 can be provided by extrusion. In other words, the groove-shaped structure 17 can be formed on the boiling surface part 13 by applying extrusion in the direction A to the mount 11 on which the boiling surface part 13 is formed. Here, the boiling surface part 13 may be formed on one side surface of an extruded material, which is separate from the mount 11, and another side surface of the extruded material may be joined to a surface 11b of the mount 11.

In the first embodiment, the forming the boiler 10 includes joining the mount 11 on which the boiling surface part 13 is provided to a reservoir 12 as shown in FIG. 12. For example, four sides (entire periphery) of a contact area between the mount 11 and the reservoir 12 are welded to the reservoir 12 with the mount 11 being orientated to bring an orientation of the first grooves 14a (direction A) in coincidence with the X direction (see FIG. 5) and with the mount 11 being arranged at a position that covers a window 12d of the reservoir 12 (in this case, with the boiling surface part 13 being placed inside the window 12d).

The method for producing the cooler 100 includes joining the boiler 10 to the condenser 20 as shown in FIG. 13. For example, peripheral parts on an upper end surface of the reservoir 12 (outer edges of an end surface of the peripheral wall 12b) is joined to a lower surface of the condenser 20 by welding. The cooler 100 is finally formed. Subsequently, the heat source HS is mounted to the mounting surface 11a of the mount 11.

### (Advantages of First Embodiment)

In the first embodiment, the following advantages are obtained.

In the first embodiment, as described above, since the boiling surface part 13 includes grooves 14 (see FIG. 6) that extend in a line shape and have an irregularly protruding/recessed shape shaped by melting and solidification of a material by energy beam processing, the grooves 14 having the irregularly protruding/recessed shape and formed on the boiling surface part 13 serve as a starting point of nucleate boiling, and improve a generation rate of bubbles BG. Also, since the protruding/recessed shape is not a hole whose perimeter is closed but a groove 14 extending in a line shape, no wall is formed at least an extension direction of the grooves so that the liquid-phase refrigerant 5 can flow through the grooves 14. In other words, since a pair of interior surfaces (interior walls 16c, see FIG. 10) are formed in a width direction of the grooves 14, the generation rate of bubbles BG can be increased by securing a large heat transfer area to the liquid-phase refrigerant 5; and since no interior surfaces (interior walls 16c) are formed in the extension direction of the grooves 14, the liquid-phase refrigerant 5 can be smoothly supplied from the outside of the grooves 14 into the grooves 14 when the bubbles BG generated leave the grooves 14. Consequently, it is possible to prevent occurrence of localized dryout while increasing the generation rate of bubbles BG on the boiling surface part 13 by forming protrusions/recesses.

In the first embodiment (see FIG. 6), as described above, since the grooves 14 include a spaces 15a to 15d formed of at least one of a hole opened in the boiling surface part 13, a hollow with at least a part of an opened part of the hole being covered, a lateral hole extending laterally from the hole or the hollow, and a tunnel-shaped pathway with a part of an opening in the groove 14 being covered, the starting point of nucleate boiling can be be effectively formed on the boiling surface part 13. Consequently, it is possible to effectively improve the generation rate of bubbles BG on the boiling surface part 13.

In the first embodiment (see FIG. 6), as discussed above, since each of the spaces 15a to 15d is a structure partially formed in a part of the groove 14, very small spaces 15a to 15d suitable for generation of bubbles BG can be provided in the groove 14 as a partial structure of the groove 14.

In the second example of the first embodiment (see FIG. 8), as described above, since at least a part of the groove 14 has a bottom 16a that is wider than an opening width W1 of the groove 14 in a cross section perpendicular to an extension direction of the groove 14, a width of the interior space of the groove 14 is larger than an opening width W1 of the groove, and the interior space is formed to surround a bubble BG generated on a bottom 16a of the groove 14 from both sides to the opening 16b. Accordingly, it is possible to increase an interior surface area (heat transfer area) of the groove 14. Consequently, it is possible to efficiently transfer heat the refrigerant 5 in the groove 14.

In the first embodiment (see FIG. 4), as described above, since the plurality of grooves 14 include two or more first grooves 14a extending in a first direction (direction A) along the boiling surface part 13, and two or more second grooves 14b extending in a second direction (direction B) different from the first direction (direction A) along the boiling surface part 13 and intersecting the two or more first grooves 14a, it is possible to more efficiently supply the liquid-phase refrigerant 5 in the extension direction of the grooves 14 as compared with a structure in which line-shaped grooves are arranged simply in parallel, for example. Consequently, it is possible to more effectively prevent occurrence of localized dryout in the grooves 14.

In the first embodiment (see FIG. 5), as described above, since the first direction (direction A) is a direction from the boiling surface part 13 toward the communication part 12c side in the boiler 10, a flow direction of the refrigerant 5 in circulation of the refrigerant 5 between the boiler 10 and the condenser 20 can agree with the first direction (direction A), which is an extension direction of the first grooves 14a the number of which is greater. In other words, since the liquid-phase refrigerant 5 returning from the condenser 20 to the boiler 10 flows into the boiler 10 from the communication part 12c and moves through the boiler 10 to a position of the boiling surface part 13, a flow of the liquid-phase refrigerant 5 is formed roughly in the same direction as the first direction (direction A). Also, since the number of the first grooves 14a is larger than the number of the second grooves 14b, the liquid-phase refrigerant 5 can be more effectively supplied into the first grooves 14a in the flow direction of the liquid-phase refrigerant **5.** Consequently, it is possible to further effectively prevent occurrence of localized dryout in the grooves 14.

In the third example of the first embodiment (see FIG. 9), as described above, since the boiling surface part 13 includes a plurality of first regions 17a on which the grooves 14 are formed, and second regions 17b which are arranged between the plurality of first regions 17a and on which no grooves 14 are formed, it is possible to provide the boiling surface part 13 with the first regions 17a in which generation efficiency of bubbles BG is relatively high, and second regions 17b in which generation efficiency of bubbles BG is relatively low and a large amount of liquid phase refrigerant 5 exists between the first regions 17a. Consequently, for example, even under conditions in which heat flux is large and dryout is likely to occur in the grooves 14 formed in the first regions 17a, it is possible to provide an effect of supplying the liquid-phase refrigerant 5 from the second regions 17b to the first regions 17a. As a result, it is possible to prevent occurrence of dryout in the grooves 14.

Also, in the example shown in FIGS. 9(C) and 9(D) in the third example, as described above, each of the plurality of first regions 17a is formed in a stepped shape shifted with respect to the second region 17b adjacent to the first region in a thickness direction of the boiling surface part 13, a relatively large groove-shaped first structure (groove-shaped structure 17) having a relatively large groove shape is formed on the boiling surface part 13 by the first regions 17a and the second regions 17b adjacent to each other, while a second groove-shaped structure having a relatively small groove shape is formed on surfaces of the first regions 17a in the first structure 17 by the grooves 14. Consequently, a heat transfer area (a surface area in contact with the liquid-phase refrigerant 5) of the boiling surface part 13 can be large as compared with a case in which only the grooves 14 are provided on the flat boiling surface part 13.

In the first embodiment, as described above, since the grooves 14 have a maximum opening width not smaller than 1 µm and smaller than 1 mm, it is possible to provide the grooves 14 whose size is suitable for serving as the starting point of nucleate boiling in the liquid-phase refrigerant 5. Consequently, it is possible to effectively improve the generation rate of bubbles BG on the boiling surface part 13.

### (Formation Pattern of Groove of First Modified Example)

A formation pattern of a groove 14 according to a first modified example of the groove shown in FIG. 4 is shown in FIG. 14. In the exemplary formation pattern shown in FIG. 14, only one groove 14 is provided on the boiling surface part 13. The groove 14 extends in the direction A, turns to the direction-B side at ends of the groove 14 within a formation area to extend in the direction A, and then extends in the direction opposite to the direction A so as to extend meandering at right angles. The groove 14 is formed in a meandering shape (meander shape) in the entire predetermined area including the region FP, which overlaps the installation area of the heat source HS (see FIG. 3), by repeating this meander extension a plurality of times. In FIG. 14, line segments LS adjacent to each other in the single groove 14 are illustratively arranged at the same constant pitch Pt1 as the pitch in FIG. 4.

### (Formation Pattern of Groove of Second Modified Example)

A formation pattern of a groove 14 according to a second modified example of the groove is shown in FIG. 15. In the exemplary formation pattern shown in FIG. 15, only one groove 14 is provided on the boiling surface part 13. The groove 14 is formed in a spiral-shaped pattern. The groove 14 is formed in the spiral shape so that its radius increases from a center of the region FP, which overlaps the installation area of the heat source HS (see FIG. 3), toward an outer periphery of the installation area. Line segments LS that form the spiral shape have a straight-line shape. The groove 14 is formed in the spiral shape in the entire predetermined area including the region FP, which overlaps the installation area of the heat source HS (see FIG. 3). In FIG. 15, line segments LS adjacent to each other in the single groove 14 are illustratively arranged at the same constant pitch Pt1 as the pitch in FIG. 4.

### (Formation Pattern of Groove of Other Examples)

The formation pattern of the groove 14 is not limited to the examples shown in FIGS. 4, 14 and 15. For example, the groove 14 may be formed in an annular pattern. For example, a plurality of annular grooves 14 may be concentrically formed (e.g., concentric circles or concentric rectangles). The groove 14 is not limited to a straight line, but may extend in a curved line.

### (First Modified Example of First Embodiment)

A cooler according to a first modified example of the first embodiment is now described with reference to FIG. 16. In the first modified example, an example in which the mount 11 and the reservoir 12 (see FIG. 3) are integrally formed is described dissimilar to the aforementioned first embodiment in which the mount 11 is joined to the reservoir 12 by welding.

In the example shown in FIG. 16, a recessed part 11c is provided in the mount 11. An interior space of the recessed part 11c serves as the interior space of the reservoir 12 of the aforementioned first embodiment (see FIG. 12). For this reason, in FIG. 16, the reservoir 12 is not provided as a separate part. An interior bottom of the recessed part 11c forms the surface 11b, and the boiling surface part 13 is formed on this surface 11b.

In the example shown in FIG. 16, the joining the boiler 10 to the condenser 20 includes joining the mount 11 to the condenser 20 by brazing. In this joining, a brazing sheet 30 including a core material and a brazing material on both sides of the core material is arranged between the condenser 20 and the mount 11. The mount 11 is joined onto the condenser 20 through the brazing sheet 30 by brazing. As a result, the boiler 10 is joined to the condenser 20, and production of the cooler 100 is completed. After that, the heat source HS is attached to the mounting surface 11a of the mount 11.

Here, an assembly of the parts assembled from parts forming the boiler 10 and parts forming the condenser 20 may be prepared after forming the grooves 14 on the boiling surface part 13, and brazing may be applied to the entire assembly. In this case, the forming the condenser 20, the forming the boiler 10, and the joining the boiler 10 to the condenser 20 can be performed together in a single brazing process.

### (Second Modified Example of First Embodiment)

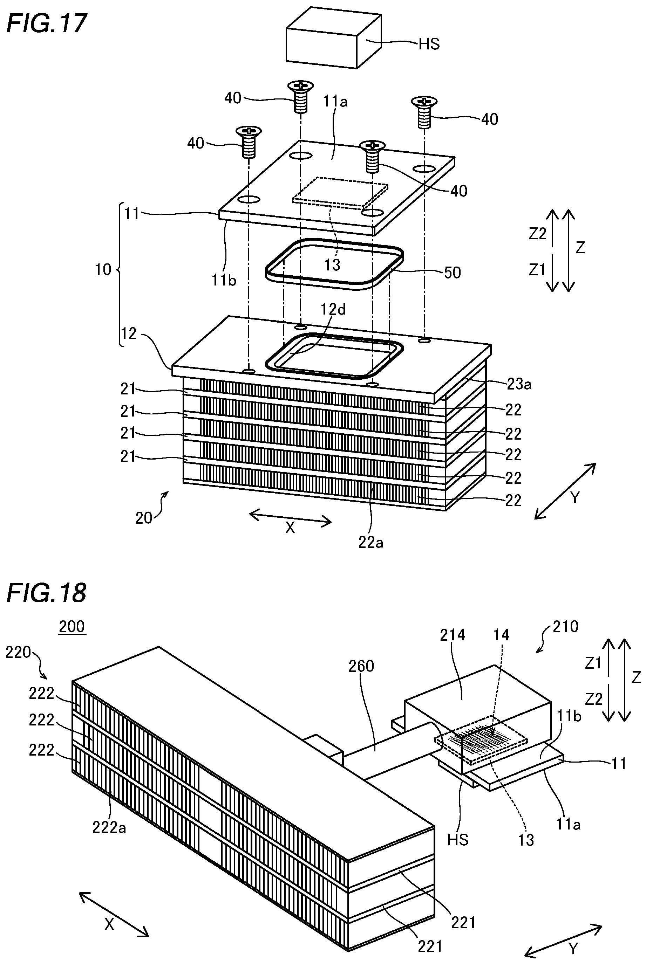

A cooler according to a second modified example of the first embodiment is now described with reference to FIG. 17. In the second modified example, an example in which the mount 11 is joined to the reservoir 12 by screwing is described dissimilar to the aforementioned first embodiment in which the mount 11 is joined to the reservoir 12 by welding.

As shown in FIG. 17, the forming the boiler 10 includes joining the mount 11 to the reservoir 12 by screwing. In this case, the mount 11 has insertion holes for receiving screws 40, and the reservoir 12 has internally threaded holes with which the screws 40 threadedly engage. Also, a seal 50 such as an O-ring is arranged between the reservoir 12 and the mount 11. The mount 11 is fixed onto the reservoir 12 by screwing the screws 40 with the seal 50 being interposed between the reservoir and the mount. As a result, the reservoir 12 is formed so that the boiler 10 is formed. In this example, the reservoir 12 may be previously joined to the condenser 20. Also, even in the case of screwing, the seal 50 can seal the refrigerant 5 in the reservoir 12. After that, the heat source HS is attached to the mounting surface 11a of the mount 11.

### [Second Embodiment]

A configuration of a boiling cooler 200 (hereinafter, referred to as cooler 200) according to a second embodiment of the present invention is now described with reference to FIGS. 18 to 20. In the second embodiment, an example in which the boiler 210 and the condenser 220 are separated is described dissimilar to the aforementioned first embodiment in which the boiler 10 and the condenser 20 are integrated. Hereinafter, the same components as those of the first embodiment are denoted by the same reference numerals, and their description is omitted.

As shown in FIGS. 18 to 20, the cooler 200 includes a boiler 210, a condenser 220 and a connector 260. The boiler 210 boils the refrigerant 5 by transferring heat from the heat source HS. The condenser 220 condenses the refrigerant 5 boiled by the boiler 210 and returns the boiled refrigerant to the boiler 210. The connector 260 is a connecting tube that connects the boiler 210 to the condenser 220 so that they communicate with each other. The cooler 200 according to the second embodiment is a separate type in which the boiler 210 and the condenser 220 are located apart from each other and are connected to each other through the connector 260. Here, the refrigerant 5 is not shown in the second embodiment (FIGS. 18 to 20).

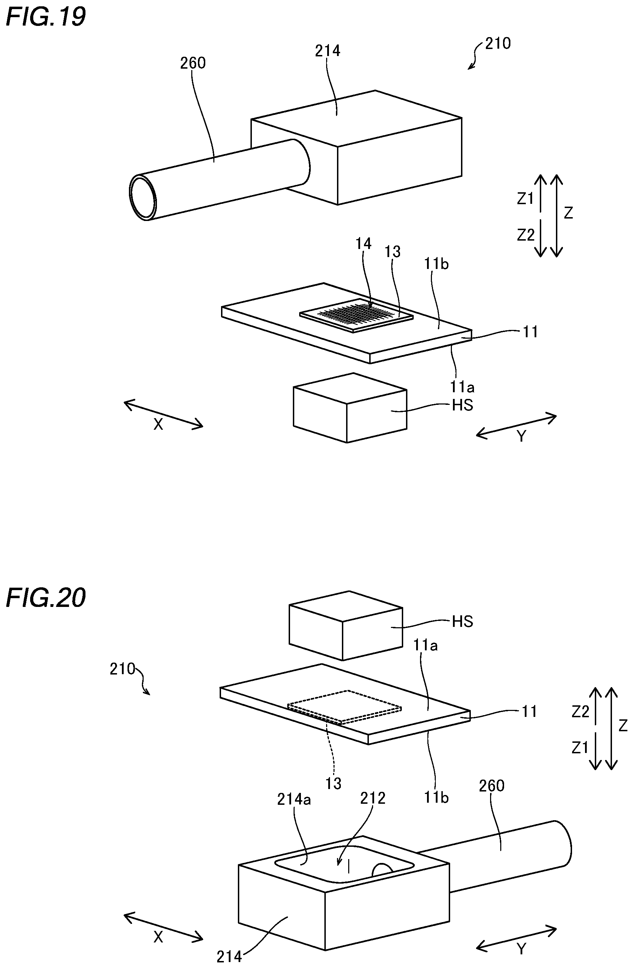

The boiler 210 includes the mount 11 and a reservoir 212 (see FIG. 20). The reservoir 212 accommodates the refrigerant 5 in a liquid phase. The reservoir 212 is defined by a recessed part 214a (see FIG. 20) formed in a body 214 of the boiler 210 and the surface 11b of the mount 11. The reservoir 212 is provided as a box-shaped space. The boiling surface part 13 is in contact with the liquid-phase refrigerant 5 in the reservoir 212. Here, since the boiling surface part 13 is similar to the aforementioned first embodiment, although not described in detail, the grooves 14 are formed by energy beam processing on the boiling surface part 13.

The condenser 220 is configured as a plate-fin type heat exchanger. The condenser 220 includes refrigerant flow paths 221 and external flow paths 222. The refrigerant flow paths 221 and the external flow paths 222 are alternately arranged with partition plates being interposed between the refrigerant and external flowpaths. The refrigerant flow paths 221 are flow paths through which the refrigerant 5 flows. The refrigerant flow paths 221 communicate with the reservoir 212 of the boiler 210 through the connector 260. Corrugated fins (not shown) are arranged to extend in the X direction inside the refrigerant flow paths 221. The external flow paths 222 are flow paths through which an external fluid flows. The external flow paths 222 are opened toward the outside. Corrugated fins 222a are arranged to extend in the Y direction in the external flow paths 222.

When the heat from the heat source HS is transferred to the boiling surface part 13 through the mount 11, the liquid-phase refrigerant 5 in the reservoir 212 is heated and boiled. The refrigerant 5 that is vaporized by boiling moves through the connector 260 into the refrigerant flow paths 221, which communicate with the reservoir 212, and is cooled and condensed by the external fluid flowing through the external flow paths 222. The refrigerant 5 that is liquefied by condensation moves through the refrigerant flow paths 221 and the connector 260, and returns to the reservoir 212. Accordingly, the refrigerant 5 enclosed in the cooler 200 is circulated between the boiler 210 and the condenser 220. As a result, the heat source HS is cooled.

### (Boiling-Cooler Production Method)

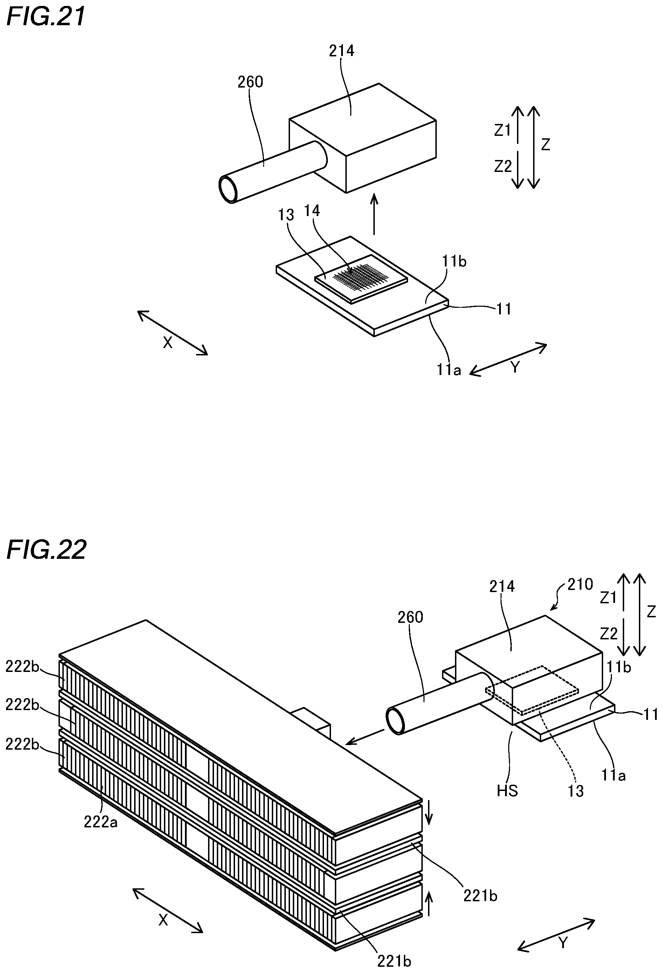

A method for producing the cooler 200 according to the second embodiment is now described with reference to FIGS. 21 to 23.

As shown in FIG. 21, the method for producing the cooler 200 includes forming the boiler 210. The forming the boiler 210 includes forming the boiling surface part 13, and joining the mount 11 to the body 214. Since the forming the boiling surface part 13 is similar to the aforementioned first embodiment, although not described in detail, the forming the boiler includes forming on the boiling surface part 13 grooves 14 that have an irregularly protruding/recessed shape shaped by applying groove formation processing by irradiating the boiling surface part 13 with an energy beam EB in a line-shaped pattern.

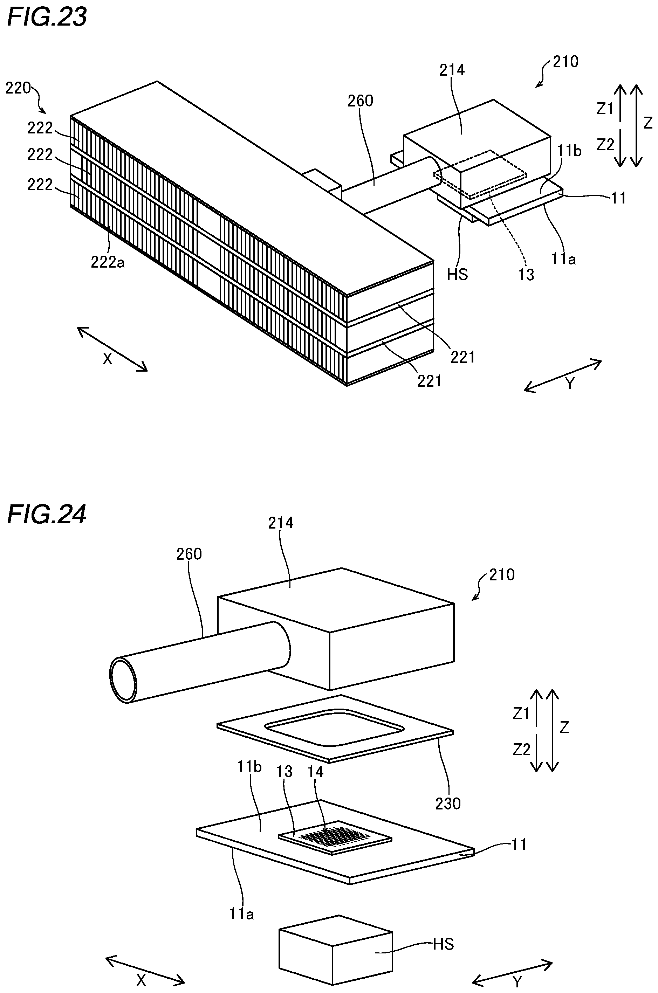

The joining the mount 11 onto the body 214 includes joining the mount 11 to the body 214 by welding. In this joining, four sides (entire periphery) as contact parts of the mount 11, which are in contact with the body 214, are welded, for example. Also, the reservoir 212 is formed by joining the mount 11 onto the body 214 by welding. As a result, the boiler 210 is formed. As shown in FIG. 22, the method for producing the cooler 200 includes forming the condenser 220. The forming the condenser 220 includes forming the condenser 220 by joining refrigerant flow-path elements 221b, which will serve as the refrigerant flow paths 221, to external flow-path elements 222b, which will serve as the external flow paths 222. In addition, the method for producing the cooler 200 includes joining the boiler 210 to the condenser 220 through the connector 260. Accordingly, production of the cooler 200 is completed. After that, the heat source HS is attached to the mounting surface 11a of the mount 11, as shown in FIG. 23.

The other configuration of the second embodiment is similar to the first embodiment.

### (Advantages of Second Embodiment)

In the boiling cooler 200 and the method for producing the boiling cooler 200 according to the second embodiment, since the grooves 14 that have an irregularly protruding/recessed shape shaped by melting and solidification of a material by energy beam processing are formed on the boiling surface part 13 by applying groove formation processing by irradiating the boiling surface part 13 with an energy beam EB in a line-shaped pattern, it is possible to prevent occurrence of localized dryout while increasing the generation rate of bubbles BG on the boiling surface part 13 by forming protrusions/recesses similar to the first aforementioned embodiment.

The other advantages of the second embodiment are similar to the first embodiment.

### (First Modified Example of Second Embodiment)

A cooler according to a first modified example of the second embodiment is now described with reference to FIG. 24. In the first modified example, an example in which the mount 11 is joined to the body 214 by brazing is described dissimilar to the aforementioned second embodiment in which the mount 11 is joined to the body 214 by welding.

As shown in FIG. 24, the joining the mount 11 onto the body 214 includes joining the mount 11 to the body 214 by brazing. In this joining, a brazing sheet 230 including a core material and a brazing material on both sides of the core material is arranged between the body 214 and the mount 11. The mount 11 is joined onto the body 214 through the brazing sheet 230 by brazing. The reservoir 212 is formed by brazing the mount 11 onto the body 214. As a result, the boiler 210 is formed, and production of the cooler 200 is completed. After that, the heat source HS is attached to the mounting surface 11a of the mount 11.

### (Second Modified Example of Second Embodiment)

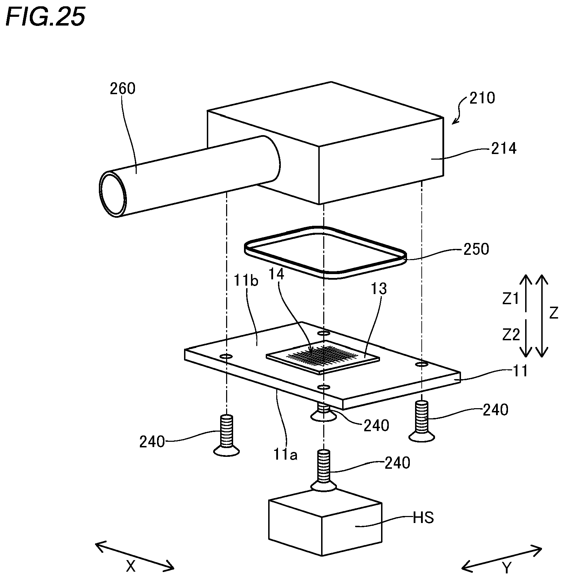

A cooler according to a second modified example of the aforementioned first embodiment is now described with reference to FIG. 25. In the second modified example, an example in which the mount 11 is joined to the body 214 by screwing is described dissimilar to the aforementioned first embodiment in which the mount 11 is joined to the body 214 by welding.

As shown in FIG. 25, the joining the mount 11 onto the body 214 includes joining the mount 11 to the body 214 by screwing. In this case, the mount 11 has insertion holes for receiving screws 240, and the body 214 has internally threaded holes with which the screws 240 threadedly engage. Also, a seal 250 such as an O-ring is arranged between the body 214 and the mount 11. The mount 11 is fixed onto the body 214 by screwing the screws 240 with the seal 250 being interposed between the body and the mount. As a result, the reservoir 212 is formed so that the boiler 210 is formed, and production of the cooler 200 is completed. Also, even in the case of screwing, the seal 250 can seal the refrigerant 5 in the reservoir 212. After that, the heat source HS is attached to the mounting surface 11a of the mount 11.

### [Modified Embodiments]

Note that the embodiment disclosed this time must be considered as illustrative in all points and not restrictive. The scope of the present invention is not shown by the above description of the embodiments but by the scope of claims for patent, and all modifications (modified embodiments) within the meaning and scope equivalent to the scope of claims for patent are further included.

While the example in which the boiling coolers are a horizontal type boiling cooler including a horizontal boiling surface part has been shown in the aforementioned first and second embodiments, the present invention is not limited to this. In the present invention, the boiling cooler may be a vertical type boiling cooler including a vertical boiling surface part. The boiling coolers according to the aforementioned first and second embodiments are merely illustrative, and the shape and the arrangement of each part of the boiling cooler are not limited to any particular shape and any particular arrangement.

While the example in which the single boiling surface part 13 is provided has been shown in the aforementioned first and second embodiments, the present invention is not limited to this. In the present invention, a plurality of boiling surface parts 13 may be provided. A plurality of heat sources HS may be installed on the mounting surface 11a. In that case, one boiling surface part 13 may be provided (in the region FP) to corresponding one of the heat sources HS, or one boiling surface part 13 having a body area corresponding to the plurality of heat sources HS may be provided.

While the example in which an extension direction of the first grooves 14a (direction A) and an extension direction of the second grooves 14b (direction B) are perpendicular to each other has been shown in the aforementioned first embodiment (see FIG. 4), the present invention is not limited to this. The extension direction of the first grooves 14a (direction A) and the extension direction of the second grooves 14b (direction B) may not be perpendicular to each other. The first grooves 14a and the second grooves 14b may extend in any directions and may intersect each other at any angle.

While the example in which the first regions 17a and the second regions 17b have a straight-line shape has been shown in the aforementioned first embodiment (see FIG. 9), the present invention is not limited to this. The first regions 17a and the second regions 17b may be arranged in a grid shape, for example. Also, while in the example shown in FIGS. 9(C) and 9(D) the first regions 17a protrude (are protrusion parts) with respect to the second regions 17b, the first regions 17a may be recessed part (recessed grooves) depressed with respect to the second regions 17b. The groove-shaped structure 17 may be provided on the boiling surface part 13 similar to the example shown in FIGS. 9(C) and 9(D), and the grooves 14 may be formed on both the tops (parts corresponding to the first regions 17a) and the bottoms (parts corresponding to the second regions 17b) of the groove-shaped structure 17.

While the example in which the energy beam EB is a laser beam has been shown in the aforementioned first and second embodiments, the present invention is not limited to this. In the present invention, the energy beam EB may be an electron beam or an ion beam.

### Description of Reference Numerals

5; refrigerant
10, 210; boiler
11a; mounting surface
11b; surface
12c; communication part
13; boiling surface part
14; groove
14a; first groove
14b; second groove
15a, 15b, 15c; space
16a; bottom
17a; first region
17b; second region
20, 220; condenser
100, 200; cooler (boiling cooler)
HS; heat source
EB; energy beam
W1; opening width of groove
W2; width of bottom

## Claims

1. A boiling cooler comprising:
a boiler boiling a refrigerant by transferring heat from a heat source; and
a condenser condensing the refrigerant vaporized in the boiler and returning the condensed refrigerant to the boiler, wherein
the boiler includes a mounting surface on which the heat source is mounted, and a boiling surface part on a surface that is opposite to the mounting surface and is in contact with the refrigerant, and
the boiling surface part includes a groove(s) that extends/extend in a line shape and has/have an irregularly protruding/recessed shape shaped by melting and solidification of a material by energy beam processing.

2. The boiling cooler according to claim 1, wherein the groove(s) includes/include a space formed of at least one of a hole opened in the boiling surface part, a hollow with at least a part of an opened part of the hole being covered, a lateral hole extending laterally from the hole or the hollow, and a tunnel-shaped pathway with a part of an opening in the groove being covered.

3. The boiling cooler according to claim 2, wherein the space is a structure partially formed in a part of the groove.

4. The boiling cooler according to any of claims 1 to 3, wherein at least a part(s) of the groove(s) has/have a bottom wider than an opening width of the groove in a cross section perpendicular to an extension direction of the groove (s) .

5. The boiling cooler according to any of claims 1 to 3, wherein
the grooves are a plurality of grooves formed in the boiling surface part; and
the plurality of grooves include
two or more first grooves extending in a first direction along the boiling surface part, and
two or more second grooves extending in a second direction different from the first direction along the boiling surface part and intersecting the two or more first grooves.

6. The boiling cooler according to claim **5,** wherein
the boiler includes a communication part through which the refrigerant flows between the boiler and the condenser;
the first direction is a direction from the boiling surface part toward the communication part side in the boiler; and
a number of the first grooves is greater than a number of the second grooves.

7. The boiling cooler according to any of claims 1 **to 3,** wherein
the boiling surface part includes
a plurality of first regions in which the groove(s) is/are formed, and
a second region(s) arranged between the plurality of first regions having no groove.

8. The boiling cooler according to claim 7, wherein
the plurality of first regions and a plurality of second regions as the second regions are alternately arranged in the boiling surface part; and
each of the plurality of first regions is formed in a stepped shape shifted with respect to the second region adjacent to the first region in a thickness direction of the boiling surface part.

9. The boiling cooler according to any of claims 1 to 3, wherein the groove(s) has/have a maximum opening width not smaller than 1 µm and smaller than 1 mm.

10. A method for producing a boiling cooler including a boiler boiling a refrigerant by transferring heat from a heat source, and a condenser condensing the refrigerant vaporized in the boiler and returning the condensed refrigerant to the boiler, the method comprising:
forming the condenser; and
forming the boiler including a mounting surface on which the heat source is mounted, and a boiling surface part on a surface that is opposite to the mounting surface and is in contact with the refrigerant, wherein
the forming the boiler includes forming on the boiling surface part a groove(s) that has/have an irregularly protruding/recessed shape shaped by melting and solidification of a material by energy beam processing by applying groove formation processing by irradiating the boiling surface part with an energy beam in a line-shaped pattern.
